# EUROPEAN PATENT SPECIFICATION

(11) **EP 1 408 727 B1**
(45) Date of publication and mention of the grant of the patent: **12.08.2009**
(21) Application number: 03020037.2
(22) Date of filing: 04.09.2003
(51) Int. Cl.: H05K 5/02

(54) **A plug-in card for electronic data-processing devices**
Steckkarte zur elektronischen Datenverarbeitung
Carte enfichable pour dispositifs électroniques de traitement de données

(30) Priority: 09.10.2002 DE 10248119
(43) Date of publication of application: 14.04.2004
(73) Proprietor: ITT Manufacturing Enterprises, Inc., Wilmington, Delaware 19801 (US)
(72) Inventor: Schremmer, Andreas Michael, 73663 Berglen (DE)
(74) Representative: Dreiss

(56) References cited:
- US-A- 6 166 913
- US-B1- 6 324 076

## Description

The present invention relates to a plug-in card for electronic data-processing devices according to the preamble of Claim 1.

In a plug-in card for electronic data-processing devices of this kind disclosed in DE 44 06 644 C2, the two metallic half-shells are symmetrically constructed in such a way that the longitudinal walls reach around one another to latch over their entire length. This has advantages in terms of manufacturing technique and results in a good screening of the components disposed inside. However, it has emerged that, because the housing half-shells must first be twisted in order to interlock or to reach around, assembly is not without its problems.

Further, US 6,324,076 B1 discloses an electronic card having top and bottom card shields which are connected either by a friction or latching fit between upstanding tabs at the upper card shield and appropriate recesses at the lower card shield. This friction fit connection of the two card shields is performed by a so-called true-position mismatch-match between tabs and recesses due to stamping tolerances. The latching fit connection, is formed by a sheaved portion of the planar tab.

Still further, US 6,166,913 A1 referring to a casing discloses a latching connection between an upper and a lower card shield by using a first and a second sub-frame. The second sub-frame has got latching recesses which correspond to retaining receptacles of the same lower shield. The other side of each of the upper shield and lower shield is provided with clipping tabs. The latching connection between the two shields is achieved in a way that the clipping tabs on the one side of one shield go through the receptacles in the other side of the other half and latches in the retaining receptacles of the second sub-frame.

The problem addressed by the present invention is therefore to provide a plug-in card for electronic data-processing devices of the kind mentioned above, the housing portions of which are simplified in terms of assembly technique without impairing the screening of the electronic components disposed inside.

In order to solve this problem, the features specified in Claim 1 are provided for a plug-in card for electronic data-processing devices of the kind mentioned.

A simplified assembly of the two housing portions is achieved by the measures according to the invention in such a way that the said portions, in plane disposition and displaced in perpendicular one upon the other, may be joined to latch with one another by simple plugging. Optimum screening continues to be provided.

In accordance with the preferred embodiment of the present invention, given by way of example, the latching recesses are provided directly in the longitudinal sidewall, Expedient developments emerge in this connection from the features of Claims 2 or 3.

An easy latching is made possible by the features according to one or more of Claims 4 to 6, requiring little expenditure of force on the one hand, and being achievable without difficulties and in an optimum manner on the other hand. In this connection, the free edge may conveniently rest by its middle region on the edge of the latching recess or latching slot, while the side regions of the latching edge reach behind the latching slots over the inside surface of the one longitudinal side wall.

Further advantages of the latching lugs emerge from the features of one or more of Claims 7 to 12, which result in limiting of the displacement when passing through the latching recesses.

The features according to Claim 12 contribute advantageously to the optimum screening of the electronic components arranged, for example, on a printed circuit board inside the housing, because unscreened gaps are avoided.

The features according to Claim 13 are provided in order to maintain a latching and optimum screening of this kind.

Further details of the invention are to be obtained from the following description, in which the invention is more closely described and explained with reference to the embodiments represented by way of example in the drawing, in which:
- Figure 1: is a diagrammatic perspective representation of a plug-in card for electronic data-processing devices, as defined according to a first and a second embodiment given by way of example by two housing portions made of thin sheet formed like half-shells and latched together,
- Figures 2A and 2B: are each diagrammatic perspective representation of one of the housing portions defining the housing according to Figure 1, and in accordance with a first embodiment given by way of example of the present invention,
- Figure 3: is an enlarged and detailed representation of the two housing portions according to Figures 2A and 2B disposed one over the other before they are joined or latched,
- Figure 4: is a representation corresponding to Figure 3, but with latching elements of the two housing portions engaged with one another, prior to latching,
- Figure 5: is a perspective truncated sectional representation of the two housing portions latched together with one another, but rotated through 180°,
- Figures 6A, B, 7A, B and 8A, B: are each further embodiments of latching elements in, respectively, perspective truncated representation and truncated sectional representation of the latched state of the two housing portions.

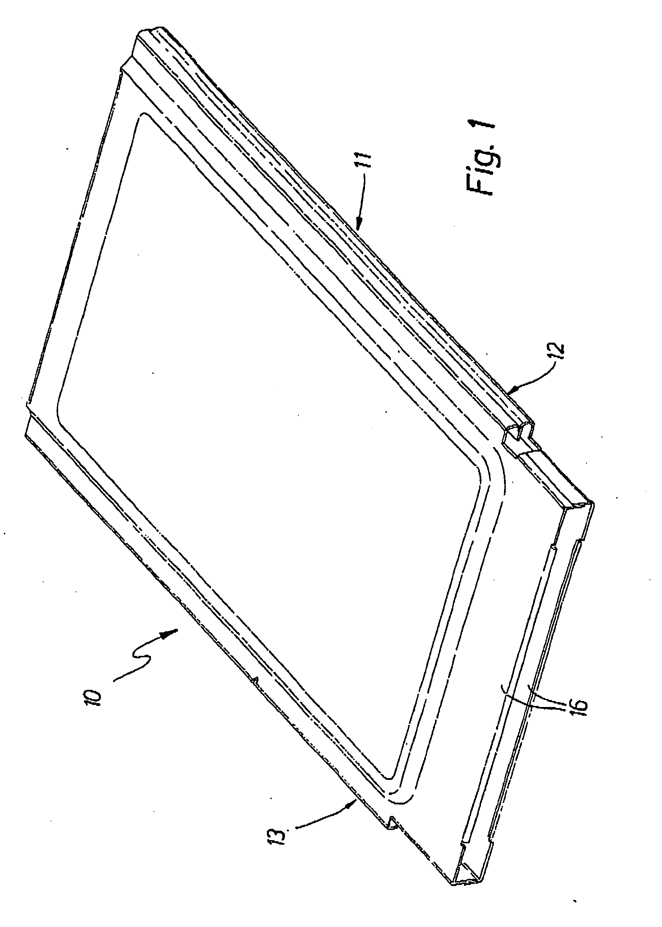

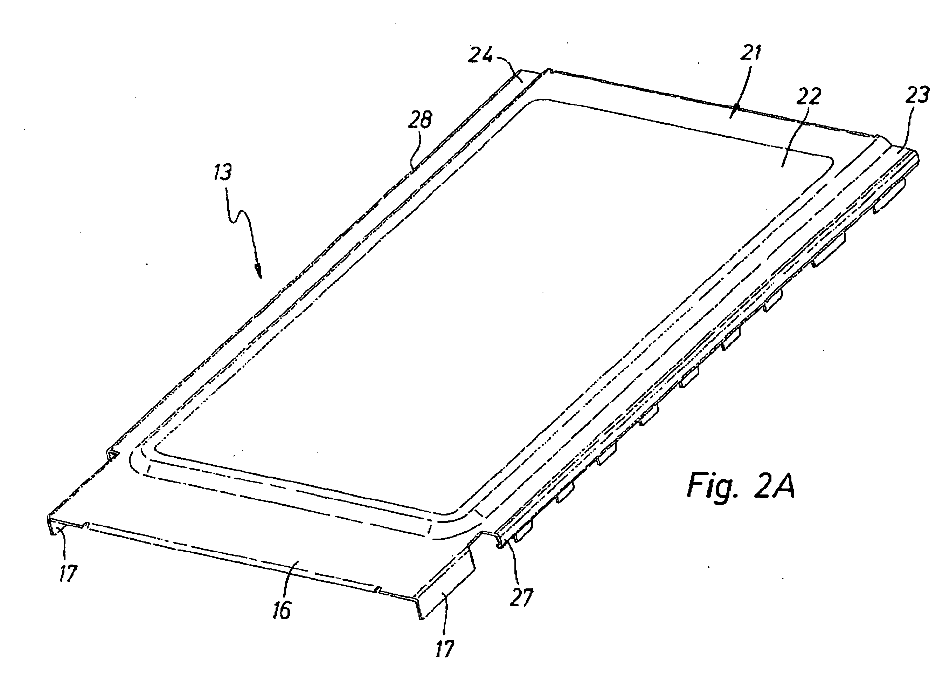

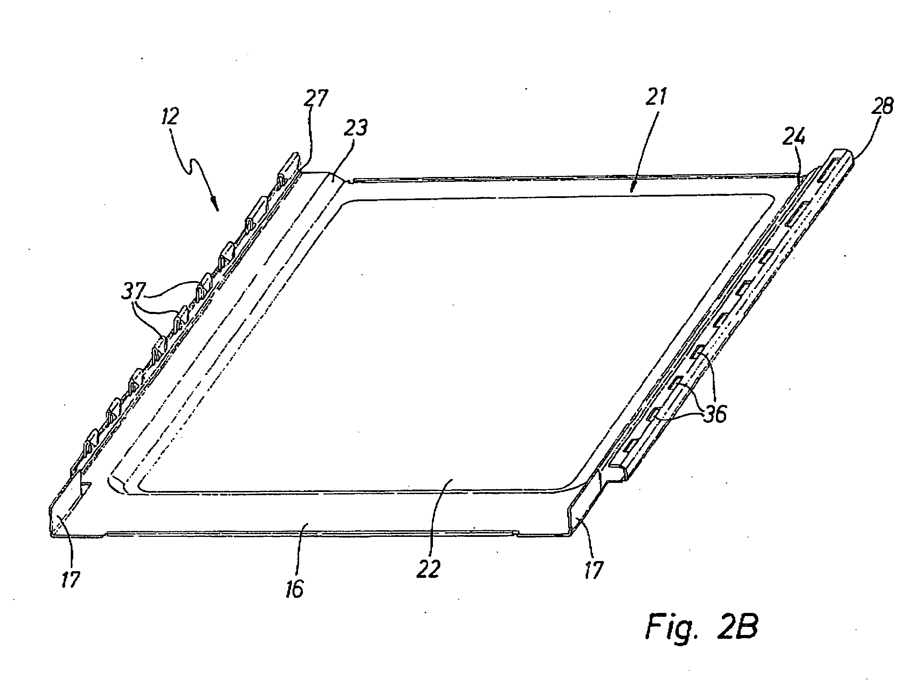

The unframed plug-in card 10 (according to Figures 2 to 5) for electronic data-processing devices, represented in assembled state in Figure 1 but without showing a male connector, has an oblong rectangular and very flat housing 11 which is comprised of a bottom housing portion 12 and a top housing portion 13 joined to the latter by latching. A unit disposed and held fixed between the two housing portions 12 and 13, in a manner not shown, has a printed circuit board populated with electronic components and a plug-in connector respectively disposed at one transverse end of and connected to the printed circuit board. Both housing portions 12 and 13 are stamped from thin sheet metal and formed to be like half shells.

In regard to the embodiment given by way of example of the plug-in card 10 in Figures 2 to 5, it may be seen from Part-Figures 2A and 2B that the two housing portions 12 and 13 are constructed identically. The housing portion 12 and 13 respectively has a base 21 which is formed to project outwards at a large-surfaced central region 22. Both longitudinal edges 23 and 24 pass into an L-shaped longitudinal wall 27 and 28 respectively. In this connection, the two legs 31 of the longitudinal wall 27 and respectively 28 perpendicular to the base 21 are the same in length, while the transverse legs 33 and respectively 34 extending parallel to the base 21 are of different length. Studs 17 bent at right angles are arranged at one plane end region 16 of the two housing portions 12 and 13, disposed within the longitudinal edges 22, 24 and overlapping one another in plugged-together state and accommodating and holding between them the male connector which is not shown.

The L-shaped longitudinal wall 28 of both housing portions 12 and 13 having the wide transverse leg 34 is provided with rectangular slots 36 disposed one after the other at equal spacing in the longitudinal direction.

By contrast, the narrow transverse leg 33 of the L-shaped longitudinal wall 27 of the two housing portions 12 and 13 is adjoined by latching lugs 37 which are likewise disposed one after the other at certain uniform spacings in the longitudinal direction.

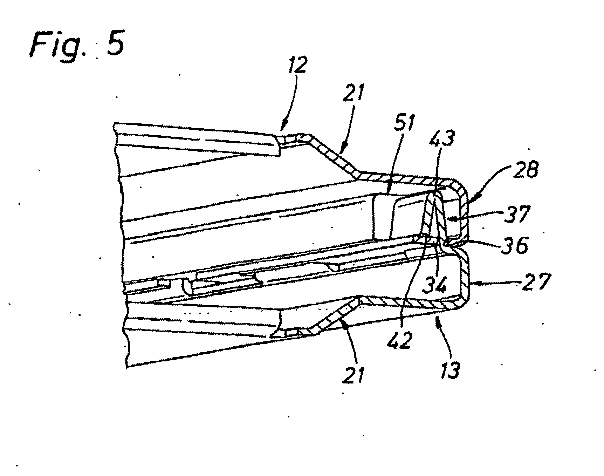

The slots 36 on one longitudinal edge 24 and the latching lugs 37 on the other longitudinal edge 27 are disposed and provided at the same spacings and in the same numbers and in substantially the same widths. The latching lugs 37 fit into and through the slots 36, so that a latching connection of the housing portions 12 and 13 as represented in Figure 5 may be effected at both longitudinal edges 23 and 24 of the plug-in card 10.

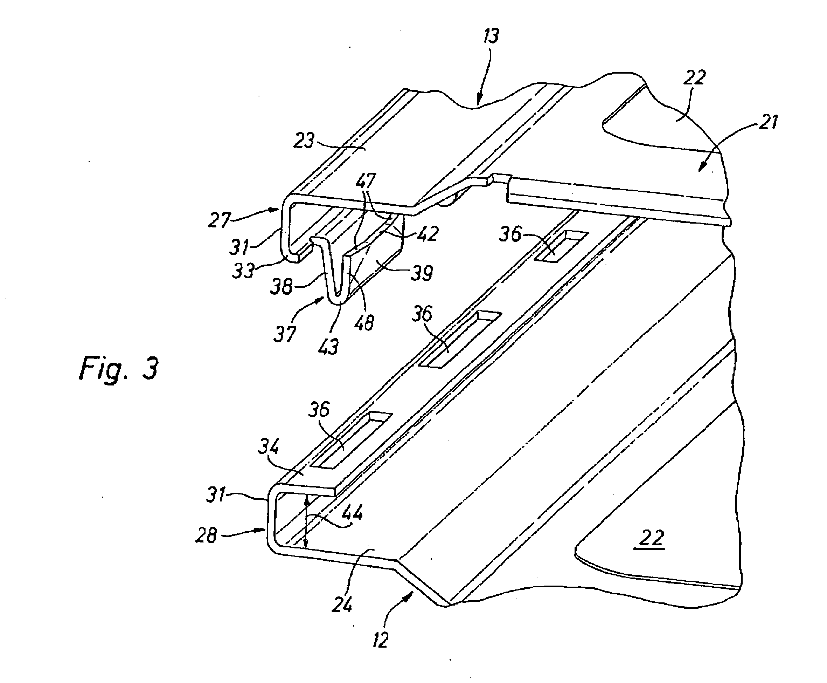

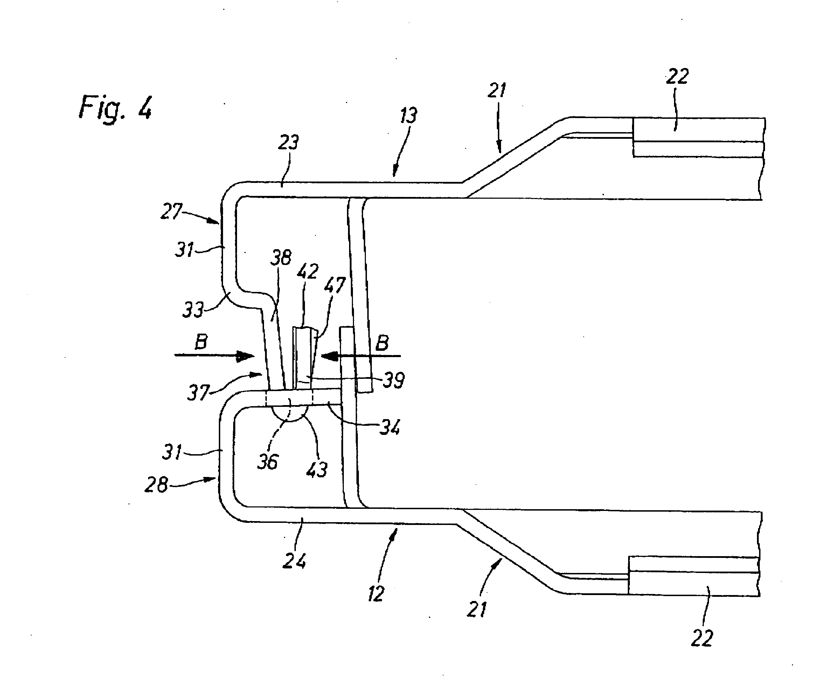

The latching lugs 37 adjoin the narrow transverse leg 33 and are bent down in a direction facing away from the base 21 to extend inward at a slight acute angle to the longitudinal leg 31 (Figures 3 and 4). The latching lugs 37 have a main portion 38 which adjoins the transverse leg 33 and is provided in one piece at its other end with a latching portion 39 which is bent back. Approximately V-shaped latching lugs 37 comprising a latching portion 39 and a main portion 38 are produced in this manner. The V-shape of the latching lug 37 is such that the latching lug 37 when pushed through the latching slot 36 can compress elastically together in the direction of the Arrow B when being pushed through, and can expand once again after the free edge 42 of the latching portion 29 has left the latching slot 36. In this connection, the spacing between the free edge 42 and the fold 43 joining the main portion 38 and the latching portion 39 is at least equal to and preferably smaller than the inside width 44 of the U-shaped longitudinal edge 24. The individual stages of placing the two housing portions 12 and 13 together can be seen in Figures 3, 4 and 5.

According to Figures 3 and 4, the free end of the latching portion 39 is shaped in the region of its free edge 42 in such a way that a slightly groove-like edge 42 is produced and that ears 47 are slightly bent down from both ends of a central region 46 towards the main portion 38. This means that, in the latched state, the ears 47 rest substantially on the inner side of the transverse leg 34. Furthermore, the latching lugs 37 are shaped slightly conically along their end face 48, in a manner not shown in detail, in order to form a chamfer for introduction into the slots 36.

According to Figure 5, the latching lugs 37 held inside the U-shaped longitudinal edge 24 in the latched state are encompassed in an approximately L-shaped manner by a preferably one-piece plastic retaining strip 51 extending over the entire length of the housing portions 12, 13. In this connection, the longitudinal leg of the L-shaped retaining strip 51 resting on the latching portion 38 has a slightly conical inner wall to correspond to the extension of the latching portion 39. The transverse leg of the L-shaped retaining strip 51 is relatively thin and rests on the fold 43 of the locating lug 37 and substantially fills out the spacing between the fold 43 and the inner surface of the base 21. The retaining strip 51, which is inserted at the respective longitudinal edge 24 before the two housing portions 12 and 13 are latched to form the housing, is held fixed in place and prevents the latching lug 37 and/or its latching portion 39 from bending up in the course of latching.

The latching of the two housing portions 12 and 13 is such that, without a tool, it can only be unlatched destructively. Furthermore, through being latched onto and into one another, the respective longitudinal walls 27 and 28 are such as to provide an optimum screening of the housing 11 in relation to the internal components.

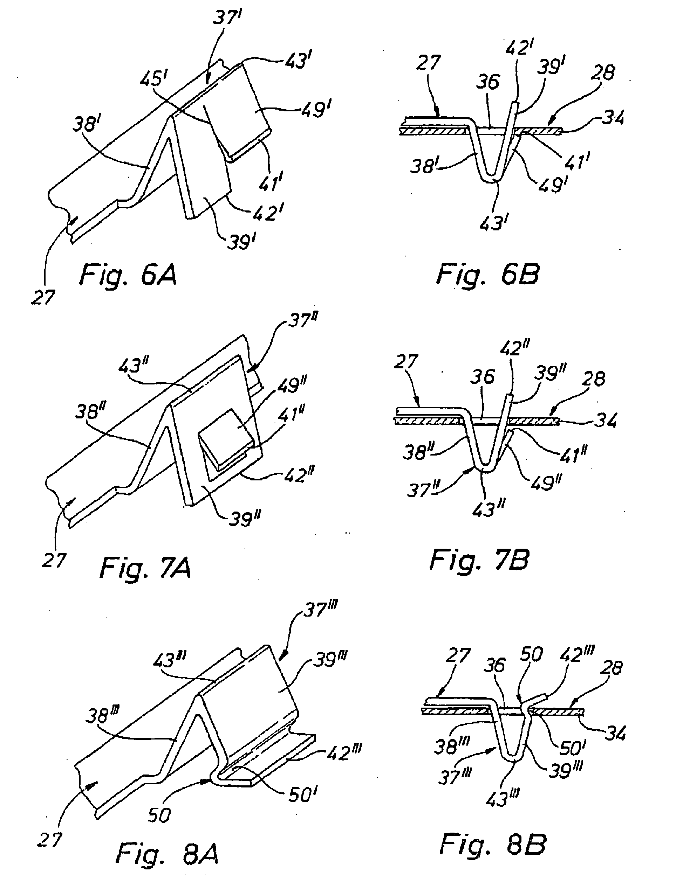

Figures 6 to 8 show further developments of the latching lugs 37 on the corresponding longitudinal wall 27 of the relevant housing portion 12 or 13, and their resultant latching disposition in the latching recesses 36 of the other longitudinal wall 28 of the opposite housing portion 13 or 12. It must first be mentioned that both the variants of the latching lugs 37 and the substantially identical latching recesses 36 are disposed in the same manner on the relevant housing portions 12,13.

The latching lug 37' according to Figures 6A and 6B, whose latching portion 39' is provided with a plane, free edge 42', has a free edge 41' in a longitudinal region which is set back in relation to the free edge 42'. The said back-set edge 41' is provided on a notch 49' which is separated from the latching portion 39' by a slot 45' near the fold 43' and is bent turning away from the main portion 38' by a small acute angle in relation to the latching portion 39'.

The length of the back-set edge 41' may correspond approximately to the length of the plane free edge 42'. It is understood that the bent notch 49' having the back-set free edge 41' may also be provided on both sides of the latching portion 39'. In the latched state shown in Figure 6B, the back-set free edge 41' reaches behind the underside of the transverse leg 34 on the longitudinal wall 28 of the relevant housing portion 12 or 13. As a result of the elastic deformation of the latching lug 37' when it passes into or respectively through the latching recess or respectively latching slot 36, the latching lug can rebound again after the notch 49' has passed through the latching slot 36, thus limiting the displacement of the latching movement.

The variant of the latching lugs 37'' according to Figures 7A and 7B is constructed in similar manner. In regard to this variant, the notch 49" is provided in a central region of the latching portion 39" of the latching lug 37''. The bending out of the notch 49''' at an acute angle produces a back-set free edge 41'' in this case also, which in the latched state reaches behind the inner side of the transverse leg 34 (Figure 7B).

In regard to the embodiment according to Figures 8A and 8B, the latching lugs 37''' are not provided with a plane, free edge on their latching portion 39''', but with a latching fold 50 which is bent to an approximately S-shape. The latching fold 50 is bent in one piece with the latching portion 39''' and at first towards the main portion 38''' and then backward, so that a latching groove 50' is produced on the inner side. Figure 8B shows the latched state, in which the latching groove 50' reaches around the relevant longitudinal edge of the latching slot 36. In this connection, the free, plane edge 42''' of the latching fold 50 reaches over the top side of the transverse leg 34 in the region of the latching slot 36 and the beginning of the S-shaped latching fold 50 rests on the inner edge of the latching slot 36.

In particular, limitation of the displacement of the latching movement when inserting the latching lugs 37''' into the latching slots 36 is also provided in this variant of the latching lug 37'''.

## Claims

1. A plug-in card (10) for electronic data-processing devices having an oblong rectangular flat shape, comprising a housing (11) which has two housing portions (12, 13) made of thin metal sheet formed like half-shells, which can be joined to latch together by their longitudinal side walls, wherein one longitudinal side wall (23) of each housing portion (12, 13) being provided with spaced apart latching lugs (37) which insert in recesses (36) provided on the other longitudinal side wall (24) of each housing portion (12, 13), wherein the recesses (36) are designed as latching recesses (36) for direct latching accommodation of the latching lugs (37), **characterized in that** the latching lugs (37) comprise a main portion (38) which adjoins the longitudinal side wall (23) and which is provided in one piece at its other end with a latching portion (39) which is bent back, forming thereby V-shaped latching lugs.

2. A plug-in card according to Claim 1, **characterised in that** the longitudinal side wall (24) provided with the latching recesses (36) adjoins the base (21) of the relevant housing portion (12, 13) in an L-shape and the latching recesses (36) are provided in a leg (28) extending approximately parallel to the base (21), and **in that** the longitudinal side wall (23) provided with the latching lugs (37) is bent inwards at a right angle at regions passing into the latching lugs.

3. A plug-in card according to Claim 1 or 2, **characterised in that** the latching lugs (37) are oblong and the latching recesses are defined by slots (36) extending in a longitudinal direction.

4. A plug-in card according to at least one of the preceding claims, **characterised in that** the latching lugs (37) have lead-in chamfers on their end faces (48).

5. A plug-in card according to either one of Claim 1 to 4, **characterised in that** the latching lug (37) extends conically in longitudinal section and is resiliently elastic in the direction of its opening.

6. A plug-in card according to at least one of Claims 1 to 5, **characterised in that** the free longitudinal edge region (42) of the latching portion (39) is bent down at both ends towards the oppositely disposed main portion (38) of the latching lug (37).

7. A plug-in card according to at least one of Claims 1 to 6, **characterised in that** the latching portion (39) is provided with a notch (49) directed to face away from the main portion (38).

8. A plug-in card according to Claim 7, **characterised in that** the notch (49) adjoins an end edge of the latching portion (39).

9. A plug-in card according to Claim 7, **characterised in that** the notch (49) is stamped out of the surface of the latching portion (39).

10. A plug-in card according to at least one of Claims 1 to 6, **characterised in that** the latching portion (39) is provided with a one piece adjoining latching fold (50).

11. A plug-in according to Claim 10, **characterised in that** the latching fold (50) is bent in approximately S-shape.

12. A plug-in card according to at least one of the preceding claims, **characterised in that** the longitudinal side walls (27, 28) of the two half-shells (12, 13) rest with their leg containing the latching recesses (36) and their longitudinal region bent at right angles one upon the another in a latched state.

13. A plug-in card according to at least one of the preceding claims, **characterised in that** the latching lugs (36) latched into the latching recesses (36) and facing the opposite housing portion (12, 13) are covered over by an L-shaped plastic strip (51).

## Patentansprüche

1. Steckkarte (10) für elektronische Datenverarbeitungsgeräte in etwa länglich rechteckiger flacher Form, mit einem Gehäuse (11, das zwei halbschalenartig ausgebildete Gehäuseteile (12, 13) aus dünnem Metallblech aufweist, die an ihren Längsseitenwänden verrastend miteinander verbindbar sind, wobei eine Längsseitenwand (23) jedes Gehäuseteils (12, 13) mit im Abstand angeordneten Rastlappen (37) versehen ist, die in Ausnehmungen (36) einrücken, die an der anderen Längsseitenwand (24) jedes Gehäuseteils (12, 13) angeordnet sind, wobei die Ausnehmungen (36) als Rastausnehmungen (36) zur unmittelbaren Rastaufnahme der Rastlappen (37) vorgesehen sind, **dadurch gekennzeichnet, dass** die Rastlappen (37) einen Hauptteil (38) aufweisen, der an die Längsseitenwand (23) angrenzt und der an seinem anderen Ende mit einem Rastteil (39) einstückig versehen ist, der rückgebogen ist, wodurch V-förmige Rastlappen gebildet sind.

2. Steckkarte nach Anspruch 1, **dadurch gekennzeichnet, dass** die mit den Rastausnehmungen (36) versehene Längsseitenwand (24) an den Boden (21) des betreffenden Gehäuseteils (12, 13) L-förmig anschließt und die Rastausnehmungen (36) in einem etwa parallel zum Boden (21) verlaufenden Schenkel (28) angebracht sind und dass die mit den Rastlappen (37) versehene Längsseitenwand (23)an zu den Rastlappen übergehenden Bereichen nach innen rechtwinklig abgekröpft sind.

3. Steckkarte nach Anspruche 1 oder 2, **dadurch gekennzeichnet, dass** die Rastlappen (37) länglich und die Rastausnehmungen durch in Längsrichtung verlaufende Schlitze (36) gebildet sind.

4. Steckkarte nach mindestens einem der vorhergehenden Ansprüche, **dadurch gekennzeichnet, dass** die Rastlappen (37) an ihren Stirnseiten (48) Einführungsschrägen besitzen.

5. Steckkarte nach einem der Ansprüche 1 bis 4, **dadurch gekennzeichnet, dass** der Rastlappen (37) im Längsschnitt konisch verläuft und in Richtung seiner Öffnung federnd elastisch ist.

6. Steckkarte nach mindestens einem der Ansprüche 1 bis 5, **dadurch gekennzeichnet, dass** der freie Längskantenbereich (42) des Rastteils(39) zu dem gegenüberliegenden Hauptteil (38) des Rastlappens (37) hin beidendig abgebogen ist.

7. Steckkarte nach mindestens einem der Ansprüche 1 bis 6, **dadurch gekennzeichnet, dass** der Rastteil (39) mit einer dem Hauptteil (38) abgewandt gerichteten Ausklinkung (49) versehen ist.

8. Steckkarte nach Anspruch 7, **dadurch gekennzeichnet, dass** die Ausklinkung (49) an eine Endkante des Rastteils (39) anschließt.

9. Steckkarte nach Anspruch 7, **dadurch gekennzeichnet, dass** die Ausklinkung (49) aus der Fläche des Rastteils (39) gestanzt ist.

10. Steckkarte nach mindestens einem der Ansprüche 1 bis 6, **dadurch gekennzeichnet, dass** der Rastteil (39) mit einem einstückig anschließenden Rastfalz (50) versehen ist.

11. Steckkarte nach Anspruch 10, **dadurch gekennzeichnet, dass** der Rastfalz (50) etwa S-förmig gebogen ist.

12. Steckkarte nach mindestens einem der vorhergehenden Ansprüche, **dadurch gekennzeichnet, dass** die Längsseitenwände (27, 28) der beiden Halbschalen (12, 13) in verrastetem Zustand mit ihrem die Rastausnehmungen(36) beinhaltenden Schenkel und ihrem abgekröpften Längsbereich aneinander anliegen.

13. Steckkarte nach mindestens einem der vorhergehenden Ansprüche, **dadurch gekennzeichnet, dass** die in die Rastausnehmungen (36) eingerasteten und zum gegenüberliegenden Gehäuseteil (12, 13) zeigenden Rastlappen (37) von einer L-förmigen Kunststoffleiste (51) überdeckt sind.

## Revendications

1. Carte enfichable (10) pour dispositif de traitement de données électronique ayant une forme plane rectangulaire oblongue, comprenant un boîtier (11) qui possède deux portions de boîtier (12, 13) réalisées en mince tôle métallique formées à la manière de demi-coques, qui peuvent être réunies pour se verrouiller ensemble par leurs parois latérales longitudinales, dans laquelle une paroi latérale longitudinale (23) de chaque portion de boîtier (12, 13) est pourvue de pattes de verrouillage écartées (37) qui s'insèrent dans des évidements (36) prévus sur l'autre paroi latérale longitudinale (24) de chaque portion de boîtier (12, 13), dans laquelle les évidements (36) sont conçus sous la forme d'évidements de verrouillage (36) pour recevoir directement en verrouillage les pattes de verrouillage (37),
**caractérisée en ce que** les pattes de verrouillage (37) comprennent une portion principale (38) qui est adjacente à la paroi latérale longitudinale (23) et qui est dotée d'un seul tenant à son autre extrémité d'une portion de verrouillage (39) qui est cintrée vers l'arrière, formant ainsi des pattes de verrouillage en forme de V.

2. Carte enfichable selon la revendication 1, **caractérisée en ce que** la paroi latérale longitudinale (24) dotée des évidements de verrouillage (36) est adjacente à la base (21) de la portion de boîtier concernée (12, 13) avec une forme en L, et les évidements de verrouillage (36) sont prévus dans un bras (28) qui s'étend approximativement parallèle à la base (21), et **en ce que** la paroi latérale longitudinale (23) dotée des pattes de verrouillage (39) est cintrée vers l'intérieur à angle droit dans des régions qui se transforment dans les pattes de verrouillage.

3. Carte enfichable selon la revendication 1 ou 2, **caractérisée en ce que** les pattes de verrouillage (37) sont oblongues et les évidements de verrouillage sont définis par des fentes (36) s'étendant dans une direction longitudinale.

4. Carte enfichable selon l'une au moins des revendications précédentes, **caractérisée en ce que** les pattes de verrouillage (37) comportent des chanfreins d'attaque sur leur face terminale (48).

5. Carte enfichable selon l'une quelconque des revendications 1 à 4, **caractérisée en ce que** la patte de verrouillage (37) s'étend de façon conique en section longitudinale, et présente une élasticité dans la direction de son ouverture.

6. Carte enfichable selon l'une au moins des revendications 1 à 5, **caractérisée en ce que** la région de bordure longitudinale libre (42) de la portion de verrouillage (39) est cintrée vers le bas aux deux extrémités en direction de la portion principale (38), disposée à l'opposé, de la patte de verrouillage (37).

7. Carte enfichable selon l'une au moins des revendications 1 à 6, **caractérisée en ce que** la portion de verrouillage (39) est dotée d'une encoche (49) dirigé de manière à se détourner de la portion principale (38).

8. Carte enfichable selon la revendication 7, **caractérisée en ce que** l'encoche (49) est adjacente à une bordure terminale de la portion de verrouillage (39).

9. Carte enfichable selon la revendication 7, **caractérisée en ce que** l'encoche (49) est estampée depuis la surface de la portion de verrouillage (39).

10. Carte enfichable selon l'une au moins des revendications 1 à 6, **caractérisée en ce que** la portion de verrouillage (39) est dotée d'un pli de verrouillage adjacent (50) d'un seul tenant.

11. Carte enfichable selon la revendication 10, **caractérisée en ce que** le pli de verrouillage (50) est cintré approximativement en forme de S.

12. Carte enfichable selon l'une au moins des revendications précédentes, **caractérisée en ce que** les parois latérales longitudinales (27, 28) des deux demis-coques (12, 13) reposent avec leurs bras contenant les évidements de verrouillage (36) et leurs régions longitudinales cintrées à angle droit l'une sur l'autre dans un état verrouillé.

13. Carte enfichable selon l'une au moins des revendications précédentes, **caractérisée en ce que** les pattes de verrouillage (36) verrouillées dans les évidements de verrouillage (36) et tournées vers la portion de boîtier opposée (12, 13) sont couvertes par une bande en matière plastique (51) en forme de L.
